# EUROPÄISCHE PATENTANMELDUNG

(11) **EP 4 012 435 A1**
(43) Veröffentlichungstag der Anmeldung: **15.06.2022**
(21) Anmeldenummer: 20212809.6
(22) Anmeldetag: 09.12.2020
(51) Int. Cl.: G01R 33/565, G01R 33/36

(54) **COMPUTERIMPLEMENTIERTES VERFAHREN ZUM BETRIEB EINER MAGNETRESONANZEINRICHTUNG, MAGNETRESONANZEINRICHTUNG, COMPUTERPROGRAMM UND ELEKTRONISCH LESBARER DATENTRÄGER**

(71) Anmelder: Siemens Healthcare GmbH, 91052 Erlangen (DE)
(72) Erfinder: Brinker, Gerhard, 91054 Erlangen (DE); Popescu, Stefan, 91056 Erlangen (DE)

(57) **Zusammenfassung**

Computerimplementiertes Verfahren zum Betrieb einer Magnetresonanzeinrichtung (22), die wenigstens eine über wenigstens zwei Ansteuerkanäle ansteuerbare Sendespule (1, 6, 25, 26), der eine Sendeelektronik (7) zugeordnet ist, und eine Steuereinrichtung (27) aufweist, wobei die Steuereinrichtung (27) zur Ansteuerung der Sendespule (1, 6, 25, 26) zur Erzeugung eines Anregungsfeldes gemäß Sendesteuerparametern, die Phasenunterschiede und/oder relative Amplituden für die Ansteuerkanäle beschreiben, ausgebildet ist, wobei bei der Aufnahme eines Magnetresonanzdatensatzes eines interessierenden Bereichs eines Patienten (15) zur Ansteuerung der wenigstens einen Sendespule (1, 6, 25, 26)
- wenigstens ein die Körperform, insbesondere Körperkontur, des Patienten (15) wenigstens in einer den interessierenden Bereich umfassenden Körperregion und/oder die Körperregion beschreibender Körperformparameter ermittelt wird,
- Sendesteuerparameter für die Sendespule (1, 6, 25, 26) mittels eines vorbestimmten, in der Steuereinrichtung (27) abgelegten Ermittlungszusammenhangs ermittelt werden, wobei der Ermittlungszusammenhang Körperformparametern bezüglich der Erzeugung eines rein zirkular polarisierten und/oder homogenen Anregungsfelds optimierte Sendesteuerparameter für die Sendespule (1, 6, 25, 26) zuordnet, und
- die Sendespule (1, 6, 25, 26) unter Verwendung der Sendesteuerparameter angesteuert wird.

## Beschreibung

Die Erfindung betrifft ein computerimplementiertes Verfahren zum Betrieb einer Magnetresonanzeinrichtung, die wenigstens eine über wenigstens zwei Ansteuerkanäle ansteuerbare Sendespule, der eine Sendeelektronik zugeordnet ist, und eine Steuereinrichtung aufweist, wobei die Steuereinrichtung zur Ansteuerung der Sendespule zur Erzeugung eines Anregungsfeldes gemäß Phasenunterschiede und/oder relative Amplituden für die Ansteuerkanäle beschreibenden Sendesteuerparametern ausgebildet ist. Daneben betrifft die Erfindung eine Magnetresonanzeinrichtung, ein Computerprogramm und einen elektronisch lesbaren Datenträger.

Die Magnetresonanzbildgebung ist eine inzwischen häufig anzutreffende medizinische Modalität. Magnetresonanzeinrichtungen, insbesondere solche mit einem supraleitenden Magneten, zeichnen sich in den meisten Fällen durch eine Hauptmagneteinheit, die den Grundfeldmagneten enthält, aus, in der eine zylindrische Patientenaufnahme ausgebildet ist, in die der Patient mittels einer Patientenliege eingefahren werden kann, um einen Aufnahmebereich innerhalb des Homogenitätsvolumens, also des Blickfelds, der Magnetresonanzeinrichtung zu platzieren. Die Magnetresonanzbildgebung basiert darauf, dass sich Kernspins innerhalb des Patienten, die vermessen werden sollen, im Grundfeld (B0-Feld) ausrichten. Mittels eines Hochfrequenzpulses (Anregungspulses), mithin eines hochfrequenten Anregungsfeldes, das üblicherweise auch als B1-Feld bezeichnet wird, werden die Spins aus ihrer Gleichgewichtslage ausgelenkt und präzidieren, wobei der Zerfall der Anregung als Magnetresonanzsignale gemessen wird. Mittels Gradientenfeldern kann eine Ortskodierung erfolgen.

Zur Erzeugung des hochfrequenten Anregungsfeldes weist die Magnetresonanzeinrichtung üblicherweise wenigstens eine Sendespule auf. Dabei ist zum einen das Konzept der Körperspule bekannt, die üblicherweise benachbart der Wand der Patientenaufnahme den Patienten weiträumig umschließt, insbesondere radial nach außen gefolgt von einer Gradientenspulenanordnung. Eine solche Ganzkörper-Sendespule wird auch als "body coil" (BC) bezeichnet. Da sich der Patient im Volumen der Sendespule befindet, spricht man auch von einer Volumen-Sendespule. Bekannt ist es jedoch auch, kleinere Volumen-Sendespulen, beispielsweise für die Untersuchung des Kopfes und/oder der Extremitäten, zu verwenden. Derartige, auch als lokale Volumen-Sendespulen bezeichneten Sendespulen können dann beispielsweise auf der Patientenliege platziert werden und mit dem entsprechend gelagerten Patienten in die Patientenaufnahme, insbesondere das Homogenitätsvolumen der Magnetresonanzeinrichtung, gefahren werden.

Dabei sei an dieser Stelle noch angemerkt, dass beispielsweise im Rahmen der spektroskopischen Magnetresonanzanwendung auch eher planare Sendespulen zum Einsatz kommen, die beispielsweise direkt auf den Körper oder unter den Körper gelegt werden können. Diese werden dann zur Unterscheidung von den Volumen-Sendespulen als Lokal-Sendespulen bezeichnet.

Mit den Volumen-Sendespulen soll im Inneren des aufzunehmenden Bereichs des Körpers des Patienten ein möglichst homogenes B1⁺-Feld mit gleichzeitig minimaler B1⁻-Komponente erzeugte werden, da die B1⁻Komponente nur eine erhöhte Leistungsabsorption bewirkt. Mit anderen Worten ist eine möglichst reine zirkulare Polarisierung erwünscht.

In der großen Mehrzahl sind die Volumen-Sendespulen bis zu 3 T Grundfeldstärke als sogenannte Birdcage-Resonatoren aufgebaut. Bei höheren Grundfeldstärken kommen vermehrt sogenannte TEM-Spulen zum Einsatz. Dabei sei die der Erfindung zugrunde liegende Problemstellung beispielhaft für eine Birdcage-Sendespule erläutert, allerdings sind die Ausführungen im Rahmen dieser Offenbarung auch auf TEM-Sendespulen analog anwendbar.

Birdcage-Sendespulen sind üblicherweise aus einer Anzahl n an Sendestäben, insbesondere 8 ≤ n ≤ 32 Sendestäben, aufgebaut, die parallel zu der Längsachse der zylindrischen Patientenaufnahme und damit zum Grundfeld orientiert sind und axial in gleichem Abstand, also 360°/n, auf einer Zylinderoberfläche verteilt sind. Die Längsenden der Sendestäbe sind durch die sogenannten Endringe miteinander leitend verbunden. Zur Einstellung der Amplituden und Phasenlagen kommen diskrete Kapazitäten zum Einsatz. Je nach konkreter Gestaltung unterscheidet man zwischen Tiefpass-, Hochpass- und Bandpass-Birdcage-Sendespulen. In vielen Ausgestaltungen weisen diese Sendespulen zwei Speisepunkte und somit zwei Ansteuerkanäle auf, da sich damit in der Theorie ein rein zirkular polarisiertes B1⁺-Feld erzeugen lässt, wobei die hinsichtlich der Magnetresonanzanwendung nicht wirksame B1⁻-Komponente dann gleich 0 ist. Unnötige Leistungsabsorption durch den Patienten soll so vermieden werden.

In einer beispielhaften Ausgestaltung können sich die Speisepunkte und somit Anschlüsse für die Ansteuerkanäle in einem geometrischen Winkelabstand von 90° an der Birdcage-Sendespule befinden. Erfolgt nun die Ansteuerung so, dass sich an beiden Speisepunkten die gleiche Amplitude A₁ = A₂ einstellt, jedoch ein Phasenunterschied von 90° verwendet wird, das bedeutet, ϕ₂ - ϕ₁ = 90°, dann wird innerhalb der leeren Birdcage-Sendespule im zentralen Bereich ein ideales, homogenes, exakt zirkular rotierendes B1⁺-Feld erzeugt, das bedeutet, B1⁻ = 0.

In der Praxis befindet sich jedoch der aufzunehmende Bereich (Aufnahmebereich) des Patienten im Zentrum der Birdcage-Sendespule, mithin Material, das Einfluss auf das erzeugte Anregungsfeld hat. Eine Verbesserungsmöglichkeit, die häufig eingesetzt wird, ist, die Volumen-Sendespulen in ihrer Form von der exakten Zylinderform abweichend zu gestalten. Der dadurch bei der Birdcage-Sendespule erzielte unterschiedliche Abstand der Sendestäbe zur Längsachse des Systems kann bereits das im Inneren des Patienten generierte B1⁺-Feld im groben Mittel verbessern. Beispielsweise sind Birdcage-Sendespulen gängig, die eine eher ovale Form aufweisen.

Zur Ansteuerung der Sendespule, insbesondere an den beiden genannten Speisepunkten, mit nur einem einzigen Hochfrequenzverstärker in der Sendeelektronik wurde vorgeschlagen, in der Sendeelektronik ferner einen sogenannten Hybrid-Splitter vorzusehen, der zwischen dem Hochfrequenzverstärker und der Volumen-Sendespule verbaut ist. Der Hybrid-Splitter teilt das auszusendende Hochfrequenzsignal in zwei Teile mit dem gewünschten Amplitudenverhältnis, beispielsweise A₁/A₂ = 1, und dem gewünschten Phasenunterschied, beispielsweise ϕ₂ - ϕ₁ = 90°, auf.

Erfahrungen in der klinischen Praxis zeigen, dass mit solch einer fixen Einstellung die Zielsetzung - Generierung eines möglichst homogenen, zirkularen B1⁺-Feldes - bei vielen Patienten nicht optimal erreicht wird. Dieses Problem ist insbesondere bei Magnetresonanzeinrichtungen, die mit höheren Grundfeldstärken und somit höheren Resonanzfrequenzen, beispielsweise bei Grundfeldstärken, die größer als 1.5 T sind, operieren, zu beobachten. Mit anderen Worten ist eine festgelegte Einstellung der Ansteuerung der Sendespule nicht für alle existierenden Körpergeometrieformen gleichermaßen optimal.

Das bedeutet, nicht für alle Patienten kann bei einer festgelegten Einstellung des Hybrid-Splitters eine Zirkularität und Homogenität des Anregungsfeldes im gewünschten Maß erreicht werden. Daher wurden im Stand der Technik bereits flexiblere Lösungen vorgeschlagen.

In einem ersten Ansatz wurde ein schaltbarer Hybrid-Splitter in der Sendeelektronik eingesetzt, mit dem genau eine weitere Kombination aus Amplitudenverhältnis und zugehöriger Phasendifferenz realisiert werden kann. Mithin existieren zwei festgelegte, über einen entsprechenden Sendesteuerparameter wählbare Varianten bezüglich des Amplitudenverhältnisses und der Phasendifferenz. Die Auswahl dieser zwei festgelegten, unterschiedlichen Varianten kann beispielsweise anhand der selektierten, zu verwendenden Hochfrequenz-Empfangsspule und/oder anhand des selektierten Untersuchungsprotokolls, beispielsweise der verwendeten Magnetresonanzsequenz, erfolgen.

In einem weiteren Ansatz wird statt dem schaltbaren Hybrid-Splitter in der Sendeelektronik ein zweiter Hochfrequenzverstärker verwendet, so dass beide Speisepunkte vollkommen unabhängig voneinander angesteuert werden können. Dies bezeichnet man als eine Zwei-Kanal-pTx-Anlage. Ähnlich wie bei der Lösung mit dem schaltbaren Hybrid-Splitter werden bei einer derartigen Ausgestaltung der Sendeelektronik in der großen Mehrzahl der Anwendungen wenige, in der Regel ebenso nur zwei, fest vorgegebene Einstellungen für die Amplitudenverhältnisse und die zugehörigen Phasendifferenzen verwendet. Die Auswahl erfolgt nach vergleichbaren Kriterien, wie sie bei den Anlagen mit den schaltbaren Hybrid-Splittern Anwendung findet. In der klinischen Praxis wird die durch die Möglichkeit der vollkommen unabhängigen Ansteuerung gegebene Flexibilität zur Generierung optimaler Anregungsfelder vergleichsweise selten ausgenutzt.

Nichtsdestotrotz wurde auch ein Ansatz vorgeschlagen, der unter dem Namen Bl-Shimming bekannt ist. Dabei wird in einem iterativen Messverfahren das generierte Anregungsfeld jeweils vermessen und im nächsten Schritt durch Variation von dem Amplitudenverhältnis und/oder der Phasenlage mit einem geeigneten Optimierungsalgorithmus optimiert. Dabei besteht allerdings das Problem, dass ein derartiger Vorgang aufgrund der wiederholten Messungen und Optimierungsschritte einen langen Zeitraum, beispielsweise ca. 30 Sekunden, in Anspruch nimmt, der auf unerwünschte Weise die Gesamtuntersuchungszeit des Patienten erhöht.

Vorgeschlagen wurde im Stand der Technik auch, weitere Speisepunkte vorzusehen, so dass mehrere Ansteuerkanäle für die Sendespule vorhanden sind. Es wurde auch bereits eine Ausgestaltung vorgeschlagen, bei der die n Sendestäbe der Sendespule mittels n Speisepunkten {1, ..., n} hinsichtlich relativer Amplitude A_{{1,.., n}} und Phasenunterschied ϕ_{{1, ..., n}} vollkommen unabhängig voneinander angesteuert werden können. Dabei sei der Phasenunterschied ϕₙ, der auch als Phasenlage bezeichnet werden kann, vorliegend als die Differenz der Phase am Speisepunkt "n" zu der Phase am Speisepunkt "1" definiert. Die Amplituden können als "auf 1 normierte Werte" mit den gewünschten Relationen zueinander bestimmt werden, wobei je nach aktueller Last die Amplituden dann durch Multiplikation mit einem passenden Faktor skaliert werden können. Magnetresonanzeinrichtungen, bei denen sich die relativen Amplituden und Phasenunterschiede an den n Speisepunkten, also für die n Ansteuerkanäle, vollkommen unabhängig voneinander einstellen lassen, werden als n-Kanal-pTx-Anlagen bezeichnet. Die maximale Anzahl von Speisepunkten entspricht einer Einzelstabansteuerung. Allerdings sind n-Kanal-pTx-Anlagen derzeit fast ausschließlich im Forschungssektor zu finden.

US 10 180 471 B2 offenbart eine Magnetresonanzbildgebungseinrichtung, bei der eine Körperdicke und Körperform gemessen werden kann. Daraus wird ein Hochfrequenzfeld abgeschätzt, dass eine Hochfrequenzspule erzeugt, wobei bei Abweichung des abgeschätzten Feldes von der Körperform gemäß einer vorgegebenen Formel die Ansteuerung der Hochfrequenzspule zur Vermeidung von stehende-Welle-Effekten angepasst wird.

Der Erfindung liegt die Aufgabe zugrunde, eine eine hohe Qualität des Anregungsfelds bereitstellende Ansteuerung der Sendespule für unterschiedliche Patienten bei möglichst geringem zeitlichen Aufwand zu erlauben.

Zur Lösung dieser Aufgabe sind erfindungsgemäß ein computerimplementiertes Verfahren, eine Magnetresonanzeinrichtung, eine Computerprogramm und ein elektronisch lesbarer Datenträger gemäß den unabhängigen Patentansprüchen vorgesehen. Vorteilhafte Ausgestaltungen ergeben sich aus den Unteransprüchen.

Bei einem Verfahren der eingangs genannten Art ist gemäß der vorliegenden Erfindung vorgesehen, dass bei der Aufnahme eines Magnetresonanzdatensatzes eines interessierenden Bereichs eines Patienten zur Ansteuerung der wenigstens einen Sendespule
- wenigstens ein die Körperform, insbesondere Körperkontur, des Patienten wenigstens in einer den interessierenden Bereich umfassenden Körperregion und/oder die Körperregion beschreibender Körperformparameter ermittelt wird,
- Sendesteuerparameter für die Sendespule mittels eines vorbestimmten, in der Steuereinrichtung abgelegten Ermittlungszusammenhangs ermittelt werden, wobei der Ermittlungszusammenhang Körperformparametern bezüglich der Erzeugung eines homogenen und/oder rein zirkular polarisierten Anregungsfelds optimierte Sendesteuerparameter für die Sendespule zuordnet, und
- die Sendespule unter Verwendung der ermittelten Sendesteuerparameter angesteuert wird.

Konkret kann, wie allgemein üblich, vorgesehen sein, auf Basis der Sendesteuerparameter die für die Erzielung eines jeweils gewünschten Flipwinkels (Kippwinkels) benötigten Ansteuerungspegel für die Ansteuerkanäle zu ermitteln und entsprechend einzusetzen. Dieser Vorgang kann auch als Transmitter-Justage bezeichnet werden. Aus der Anregung resultiert ein Magnetresonanzsignal, welches mit der Magnetresonanzeinrichtung vermessen werden kann.

Erfindungsgemäß wird mithin vorgeschlagen, einen vorbestimmten, mithin für den Aufnahmebetrieb festgelegten Ermittlungszusammenhang zu nutzen, der Körperformparametern, die beispielsweise gemessen werden können, insbesondere aber der Körperkontur in der den interessierenden Bereich umfassenden Körperregion, also auch innerhalb der Volumen-Sendespule, Sendesteuerparameter zuordnen, die ein optimales, insbesondere also möglichst rein zirkular polarisiertes und homogenes, Anregungsfeld für diesen Patienten und die anstehende Bildgebungsaufgabe ermöglichen. Denn es wurde erkannt, dass die konkrete Geometrie der Körperform des Patienten einen maßgeblichen Einfluss auf die Güte und Homogenität des bei vorgegebener Ansteuerung generierten Anregungsfeldes hat. Es wird mithin vorgeschlagen, eben diese Körperform, insbesondere die Körperkontur, des Patienten, insbesondere durch Messung, festzustellen und darauf basierend die Phasenunterschiede und/oder relativen Amplituden, einleitend bezeichnet mit ϕᵢ bzw. ϕᵢ-ϕ₁ und Aᵢ bzw. Aᵢ/A₁, wobei i von 1 bis zur Zahl der Ansteuerkanäle läuft, zur Optimierung des Anregungsfeldes zu wählen, das bedeutet, das optimierte Anregungsfeld soll möglichst homogen und möglichst rein zirkular polarisiert sein, wobei die B1⁻-Komponente minimal, insbesondere Null, sein soll.

Es wurde beispielsweise festgestellt, dass, betrachtet man eine Volumen-Sendespule für den Kopf, bei Patienten mit einer länglichen Kopfform eine bessere Bildqualität erzielt wird, wenn eine elliptische Ansteuerung, das bedeutet für zwei Ansteuerkanäle A₂/A₁ ≠ 1 und/oder ϕ₂ - ϕ₁ ≠ 90°, verwendet wird. Bei Patienten mit einer eher kugelförmigen Kopfform ist die zirkulare Ansteuerung, im Beispiel der zwei Ansteuerkanäle A₂/A₁ = 1 und ϕ₂ - ϕ₁ = 90°, vorteilhaft. Liegt der Patient mit der länglichen Kopfform auf der Seite, so kann die Orientierung der elliptischen Ansteuerung entsprechend nachgeführt werden, insbesondere, nachdem die Körperformparameter, die die Körperform, insbesondere Körperkontur, des Patienten beschreiben, in Bezug zur Magnetresonanzeinrichtung bestimmt werden, sich also auf die aktuelle, zur Magnetresonanzuntersuchung eingenommene Position des Patienten beziehen.

Es wurde nun erkannt, dass auch für weitere Körperregionen die gegebene Körperform als Kriterium für eine optimale Ansteuerung der Volumen-Sendespule verwendet werden kann. Markante Regionen, bei denen mit großen Unterschieden in der Körperform zu rechnen ist, sind beispielsweise neben dem Kopf die Brust, der Abdomen und die Beckenregion. Allein aufgrund der geschlechtsspezifischen Unterschiede ist mit großen Variationen der Körperform zu rechnen, für die gemäß der vorliegenden Erfindung eine optimierte Ansteuerung ohne massiven Zeitverlust erfolgen kann. Die Körperformparameter stellen hierbei sicher, dass die Körperform in der aktuellen Situation, gegeben durch die Lage des Patienten relativ zu der Volumen-Sendespule, gut bekannt ist, so dass mittels eines zuvor bestimmten Ermittlungszusammenhangs die für die konkrete Ausgestaltung der Magnetresonanzeinrichtung, insbesondere der Sendeelektronik der Volumen-Sendespule, optimierte Einstellung, beschrieben durch die zugeordneten Sendesteuerparameter, verwendet werden kann, so dass direkt, das bedeutet ohne zusätzliche, zeitaufwändige Justage-Schritte, beispielsweise Bl-Shimming, die optimal mögliche Bildqualität erzielt werden kann.

Das bedeutet, dass der Ermittlungszusammenhang insbesondere für die aus der Sendeelektronik und der Sendespule gebildete Sendeeinrichtung und/oder für die Magnetresonanzeinrichtung, bzw. eine entsprechende Ausstattungs- und/oder Ausgestaltungsklasse, spezifisch sein kann. Unterschiede zwischen Sendeeinrichtungen ergeben sich beispielsweise durch die konkrete Ausgestaltung der Sendeelektronik, beispielsweise die Zusammenstellung von Hochfrequenzverstärkern und/oder Hybrid-Splittern, und die Anzahl der tatsächlich vorhandenen Ansteuerkanäle(n). So kann in einer einfachen Ausgestaltung eine zweikanalige Sendespule mit einem schaltbaren Hybrid-Splitter in der Sendeelektronik verwendet werden, während in einer eher komplexen Ausgestaltung eine n-Kanal-pTx-Anlage verwendet werden kann. Die Sendespule ist hierbei eine Volumen-Sendespule, wobei es sich insbesondere um eine Birdcage-Sendespule oder eine TEM-Sendespule handeln kann.

Konkret kann mithin vorgesehen sein, dass die Sendeelektronik wenigstens einen Hochfrequenzverstärker und/oder wenigstens einen Hybrid-Splitter aufweist, die gemäß den Sendesteuerparametern zur Erzielung von zur optimierten zirkularen Polarisierung und Homogenität des Anregungsfeldes geeigneten Phasenunterschieden und/oder relativen Amplituden angesteuert werden. Grundsätzlich sind jedoch auch andere Ausgestaltungen der Sendeelektronik denkbar, die beispielsweise andere Elektronikkomponenten verwenden, um von dem wenigstens einen Hochfrequenzverstärker stammende Hochfrequenzsignale zu modifizieren und/oder aufzuteilen und/oder zusammenzuführen, beispielsweise einen Combiner.

Durch die Verwendung des Ermittlungszusammenhangs erlaubt es die vorliegende Erfindung mit besonderem Vorteil, dass für jede Situation eine optimierte Ansteuerung unmittelbar angewandt werden kann. Gegenüber der Verwendung von wenigen, fest vorgegebenen Parametersätzen ist damit eine deutliche Erhöhung der Bildqualität möglich. Eine zeitaufwändige Ermittlung optimaler Sendesteuerparameter mittels Magnetresonanzmessungen und einem Optimierungsverfahren kann eingespart werden, so dass mit geringeren Messzeiten gearbeitet werden kann und auch die Hochfrequenzbelastung des Patienten minimiert werden kann. Dabei sei darauf hingewiesen, dass selbst bei Magnetresonanzeinrichtungen, bei denen ein Bl-Shimming implementiert war, Bediener häufig auf dessen Verwendung verzichtet haben um Zeit zu sparen, und voreingestellte Sendesteuerparameter verwendet haben, was zu Bildqualitätseinbußen führen kann. Mit dem erfindungsgemäßen Ansatz stehen nun in Echtzeit geeignete Sendesteuerparameter bereit. Dabei sei angemerkt, dass mittels der vorliegenden Erfindung selbst bei Magnetresonanzeinrichtungen bzw. Volumen-Sendespulen, die nur über die Auswahlmöglichkeit aus zwei festen Verdrahtungsvarianten verfügen, der Einsatz der vorliegenden Erfindung zur Auswahl der jeweils optimalen "Verdrahtungs-Variante" genutzt werden kann, so dass auch hier im Mittel die bessere Bildqualität erzielt werden kann.

Dabei ist es ein Kern der vorliegenden Erfindung, bereits vor der Magnetresonanzuntersuchung die Körperform, insbesondere die Oberflächenkontur des Körpers (Körperkontur), zu bestimmen und für die konkrete zu untersuchende Körperregion daraus aufgrund des vorbekannten Ermittlungszusammenhangs die optimale Form der Sendesteuerparameter zu ermitteln.

Dabei kann in einer besonders vorteilhaften Ausgestaltung der vorliegenden Erfindung vorgesehen sein, dass als der Ermittlungszusammenhang eine Look-Up-Tabelle verwendet wird. In dieser Ausgestaltung wird die optimierte Form der Ansteuerung aus einer geeigneten Datenbasis direkt anhand der identifizierten Körperkontur ausgelesen. Das bedeutet, es wird eine hinreichend große Datenbasis erzeugt, wobei in der entstehenden Look-Up-Tabelle verschiedene Referenz-Körperformparametern die hierfür optimalen Sendesteuerparameter zugeordnet sind. Konkret kann dann vorgesehen sein, dass bei die Körperkontur des Patienten in der Körperregion beschreibenden Körperformparametern die Steuerparameter der Look-Up-Tabelle ausgewählt werden, deren zugeordnete Körperkontur (beschrieben durch Referenz-Körperformparameter) der Körperkontur des Patienten am besten entspricht. Es können beispielsweise Vergleichsmaße verwendet werden. Dabei sei darauf hingewiesen, dass zur Ermittlung der Körperregion als Körperformparameter im Übrigen auch im Allgemeinen die Position einer Patientenliege herangezogen werden kann, da diese letztlich bestimmt, welcher Anteil des Patienten gerade im Homogenitätsvolumen der Magnetresonanzeinrichtung, insbesondere also im Blickfeld, befindet, so dass auf diese Weise die Körperregion automatisch bestimmt werden kann. Dann muss im Fall einer Look-Up-Tabelle nur noch anhand der jeweiligen Liegenposition (Körperregion) die bestpassende Konturform in der Look-Up-Tabelle ermittelt werden und entsprechend die Ansteuerung ausgewählt und angewandt werden.

Dabei sei an dieser Stelle noch angemerkt, dass grundsätzlich auch die Verwendung anderer Ermittlungszusammenhänge denkbar ist, beispielsweise von mathematischen Formeln und/oder Algorithmen der künstlichen Intelligenz, die durch Maschinenlernen trainiert wurden. Allerdings hat sich in der Praxis gezeigt, dass bereits über eine einfach umzusetzende, recheneffektive Look-Up-Tabelle für den größten Teil der Anwendungsfälle die Bildqualität deutlich steigernde, optimierte Sendesteuerparameter anhand der Körperformparameter bestimmt werden können.

Wie bereits erwähnt, beschreiben die Körperformparameter mit besonderem Vorteil wenigstens teilweise die Körperform, insbesondere die Körperkontur. Derartige Körperformparameter können auch als Geometrieparameter bezeichnet werden und beschreiben mithin mit anderen Worten den Verlauf der Oberfläche der Körperregion wenigstens zweidimensional, bevorzugt wenigstens teilweise dreidimensional. Dabei kann auch eine abstrahiertere Beschreibung, beispielsweise die einer Einhüllenden oder angepassten geometrischen Form, gewählt werden. Beispielsweise kann bei einem Kopf des Patienten als Körperregion dieser durch eine ellipsoide Form angenähert werden, wobei die Körperformparameter als Geometrieparameter wenigstens deren Halbachsen enthalten.

Dabei sind jedoch auch andere Körperformparameter denkbar, die insbesondere zusätzlich zu die Körperform, insbesondere die Körperkontur, beschreibenden Körperformparametern nützliche weitere, auswertbare Informationen für den Ermittlungszusammenhang darstellen können. So können als Körperformparameter die Körperregion selbst und/oder die Patientenlage und/oder die Patientengröße und/oder das Patientengewicht und/oder das Patientengeschlecht verwendet werden. Dabei kann, wie bereits dargelegt wurde, beispielsweise aus der aktuellen Position der Patientenliege auf die zu untersuchende Körperregion geschlossen werden, wobei beispielsweise hierdurch auch ermöglicht werden kann, aus einer Messung am Patienten, die bei bereits auf der Patientenliege positioniertem Patienten vorgenommen wurde, die Körperkontur im korrekten Bereich als Körperformparameter zu extrahieren, wie im Folgenden noch genauer dargelegt werden wird. Werden auch weitere Körperformparameter verwendet, wie beispielsweise die Patientenlage (Kopf vorne oder Füße vorne, Seitenlage, ...), die Patientengröße, das Patientengewicht und/oder das Patientengeschlecht, kann vorgesehen sein, dass diese wenigstens teilweise aus seitens der Steuereinrichtung vorliegenden und/oder abrufbaren Patientendaten, insbesondere einer Patientenregistrierung und/oder einer elektronischen Patientenakte, ermittelt werden. Bevorzugt ist eine Messung, da diese die aktuelle Körperform am Besten wiedergibt. Grundsätzlich denkbar wäre es aber auch, falls in der Patientenakte beispielsweise ein Patientenmodell ("Digital Twin") vorliegt, die Körperkontur wenigstens teilweise aus diesem zu ermitteln.

Mit besonderem Vorteil ist im Rahmen der vorliegenden Erfindung jedoch vorgesehen, dass die Körperformparameter, insbesondere bezüglich der Körperkontur, wenigstens teilweise durch eine Messung an dem, insbesondere bereits für die Magnetresonanzbildgebung auf der Patientenliege positionierten, Patienten ermittelt werden.

Dabei sieht eine besonders vorteilhafte Ausgestaltung der vorliegenden Erfindung vor, dass die Körperkontur des Patienten mittels einer wenigstens die Körperregion erfassenden 3D-Kamera und/oder einer Terahertz-Kamera und/oder, insbesondere wenigstens teilweise beim Einfahren des Patienten auf einer Patientenliege in eine Patientenaufnahme der Magnetresonanzeinrichtung, durch Aufnahme von Magnetresonanzdaten mit der Magnetresonanzeinrichtung vermessen wird, wobei aus den Sensordaten der 3D-Kamera und/oder der Terahertz-Kamera und/oder den Magnetresonanzdaten ein die Oberfläche des Körpers des Patienten beschreibendes Konturmodell ermittelt wird, aus dem wenigstens ein Teil der Körperformparameter ermittelt wird.

In einem ersten, vorteilhaften Ansatz kann mithin vorgesehen sein, wenigstens eine 3D-Kamera und/oder wenigstens einer Terahertz-Kamera zur Vermessung der Körperform, konkret der Körperkontur, des Patienten zu verwenden. 3D-Kameras sind für Bildgebungseinrichtungen bereits grundsätzlich bekannt und können beispielsweise eine Time-of-Flight-Kamera, eine Tiefenkamera, eine Stereokamera und/oder eine Lidar-Kamera sein.

Dabei wird mit besonderem Vorteil wenigstens eine Terahertz-Kamera herangezogen, da diese durch die tatsächliche Oberfläche des Körpers des Patienten verdeckenden Stoff sowie gewissen weitere Materialien sozusagen hindurchsehen kann, um dessen tatsächliche Oberfläche zu ermitteln. Beispielsweise kann ein Scan durch wenigstens teilweise Rotation um den Patienten durchgeführt werden und/oder die wenigstens eine Terahertz-Kamera kann mit wenigstens einer 3D-Kamera kombiniert werden. Zweckmäßig ist in diesem Zusammenhang auch die Verwendung mehrerer 3D-Kameras und/oder Terahertz-Kameras, um eine möglichst vollständige Oberflächenabtastung zu erreichen, wobei für die nicht durch die wenigstens eine Kamera einsehbaren Bereiche angenommen wird, dass hier der Patient auf der Patientenliege im Wesentlichen flach bzw. der Form der Patientenliege folgend aufliegt. Die wenigstens eine 3D-Kamera und/oder die wenigstens eine Terahertz-Kamera liefert Sensordaten, die die Körperoberfläche des Patienten und somit die Körperkontur dreidimensional beschreiben. Dabei kann eine Weiterbildung der Erfindung vorsehen, dass als die wenigstens eine 3D-Kamera und/oder die wenigstens eine Terahertz-Kamera eine Kamera mit einem außerhalb der Patientenaufnahme befindlichen Erfassungsbereich verwendet wird, wobei die Sensordaten vor Einfahren des Patienten in die Patientenaufnahme aufgenommen werden, nachdem der relevante Teil des Konturmodells aufgrund des bekannten Verfahrwegs der Patientenliege ohnehin leicht ermittelt werden kann. Eine beispielhafte Ausgestaltung, wie die Körperoberfläche des Patienten vermessen werden kann, lässt sich der US 9,235,973 B2 entnehmen. Dort werden mittels einer Objektdatenerfassungseinheit Objektdaten von auf der Patientenliege positionierten Objekten erfasst, um eine Überwachung des Objekts, das auch ein menschlicher Patient sein kann, zu erreichen. Die Objektdatenerfassungseinheit kann eine 3D-Bilddatenerfassungseinheit, mithin eine 3D-Kamera, sein.

Konkret kann mithin im Rahmen der vorliegenden Erfindung vorgesehen sein, dass der bereits auf der Patientenliege gelagerte Patient, noch während sich die Patientenliege außerhalb der Patientenaufnahme befindet, mit der wenigstens einen 3D-Kamera aufgenommen wird. Die Sensordaten der wenigstens einen 3D-Kamera werden dann mittels geeigneter Software, insbesondere eines Auswertungsalgorithmus, zur Ermittlung des die Oberflächenkontur des Körpers beschreibenden Konturmodells ausgewertet.

Alternativ oder zusätzlich kann die Körperkontur auch beim Einfahren des Patienten in die Patientenaufnahme mittels einer magnetresonanzbasierten Messung durch die Magnetresonanzeinrichtung erfolgen. Konkret kann in diesem Zusammenhang beispielsweise vorgesehen sein, dass die Magnetresonanzdaten als während des Einfahrvorgangs in verschiedenen Positionen der Patientenliege aufgenommene axiale Magnetresonanzbilder aufgenommen werden, aus denen das Konturmodell bestimmt wird. Mit anderen Worten werden fortlaufend axiale Magnetresonanzbilder generiert, aus denen jeweils Umrandungslinien ermittelt werden können, die die lokale Körperkontur beschreiben. So stehen anhand der Magnetresonanzdaten dann zumindest bis zu der in die Patientenaufnahme hineingefahrene Zielposition axiale Konturlinien in Form der Umrandungslinien zur Verfügung, aus denen das Konturmodell abgeleitet werden kann.

In diesem Kontext sieht eine besonders vorteilhafte Weiterbildung der vorliegenden Erfindung jedoch vor, dass der Einfahrvorgang über eine Zielposition, in der der interessierende Bereich in einem Homogenitätsvolumen der Magnetresonanzeinrichtung positioniert ist, hinaus unter weiterer Aufnahme von Magnetresonanzdaten bis in eine Vermessungsendposition erfolgt, wonach die Patientenliege von der Vermessungsendposition in die Zielposition verfahren wird. Auf diese Weise können weitere Informationen zur Körperkontur, insbesondere Umrandungslinien, auch über die Zielposition hinaus bestimmt werden, wobei vorgesehen sein kann, dass die Vermessungsendposition grundsätzlich so gewählt wird, dass der gesamte Körper des Patienten durch die Magnetresonanzdaten vermessen werden kann. Wird also der Patient beispielsweise zunächst mit dem Kopf in die Patientenaufnahme eingefahren, kann die Vermessungsendposition so definiert sein, dass auch die Füße in wenigstens einem axialen Magnetresonanzbild noch abgebildet sind. So kann das gesamte Oberflächenprofil des Patienten als Konturmodell ermittelt werden. Wird der Patient zuerst mit den Füßen in die Patientenaufnahme hineingefahren, kann bis zu einer Positionierung des Kopfes im Homogenitätsvolumen als Vermessungsendposition fortgefahren werden, um ebenso die Körperkontur über die gesamte Länge des Patienten im Konturmodell zu erhalten.

Nachdem die Verfahrwege der Patientenliege in einer Steuereinrichtung der Magnetresonanzeinrichtung jedoch bekannt sind, kann ein natürlicher Zusammenhang zwischen dem Konturmodell und der aktuellen Position der Patientenliege gezogen werden. Mit anderen Worten ist die Position des Patienten und somit des Konturmodells bezüglich der Patientenaufnahme grundsätzlich bekannt, so dass auch festgestellt werden kann, welche Körperregion, in der sich dann der interessierende Bereich befindet, sich innerhalb des Homogenitätsvolumens, also des Blickfelds der Magnetresonanzeinrichtung, befindet. Ist die Zielposition eingenommen, ist also auch bekannt, welches die Körperregion ist, so dass in einer vorteilhaften Ausgestaltung der vorliegenden Erfindung vorgesehen sein kann, dass aus einer oder der für die Aufnahme des Magnetresonanzdatensatzes eingenommenen Zielposition der Patientenliege die Körperregion und/oder ein als Körperformparameter zu verwendender Anteil des Konturmodells bestimmt wird.

Auch zur Ermittlung des vorbestimmten Ermittlungszusammenhangs, bevor dieser bei der Aufnahme des Magnetresonanzdatensatzes eingesetzt wird, existieren erfindungsgemäß verschiedene denkbare Ansätze, die mit besonderem Vorteil auch kombiniert werden können.

So kann in einem ersten Ansatz vorgesehen sein, dass der Ermittlungszusammenhang wenigstens teilweise durch eine Vorabmessung mit einer Mehrzahl von Körperformen ermittelt wird, insbesondere aus Ergebnissen eines Bl-Shimming mit der Magnetresonanzeinrichtung für mehrere, unterschiedliche Körperformparameter aufweisende Patienten. Dabei kann bei dem B1-Shimming eine iterative, optimierende Anpassung der Sendesteuerparameter aufgrund intermittierender Messungen des Anregungsfeldes mit der Magnetresonanzeinrichtung vorgenommen werden. Dabei ist es beispielsweise denkbar, in hinreichender Anzahl gezielt Messreihen mit Probanden unterschiedlicher Körperform durchzuführen, um den Einfluss der Sendesteuerparameter auf die Bildqualität auszuwerten. Beispielsweise können die optimalen Sendesteuerparameter, insbesondere Phasenunterschiede und/oder relativen Amplituden, für alle Körperformparameter bestimmt werden, indem eine im Stand der Technik bereits bekannte iterative Optimierungsmethode, nämlich das Bl-Shimming, eingesetzt wird. Dadurch, dass der Ermittlungszusammenhang, insbesondere also die Look-Up-Tabelle, bereits im Voraus durch Bl-Shimming-Vorgänge ermittelt wird, kann die im klinischen Betrieb der Magnetresonanzeinrichtung benötigte Zeit praktisch auf Null reduziert werden, was signifikante Vorteile in der Beschleunigung klinischer Protokolle und weiterhin in der Automatisierung des Betriebs der Magnetresonanzeinrichtung mit sich bringt.

In einem zweiten, vorteilhaften Ansatz kann vorgesehen sein, dass der Ermittlungszusammenhang wenigstens teilweise durch Auswertung einer Magnetresonanzdatensätze mit zugehörigen Patientendaten und Sendesteuerparametern enthaltenden Untersuchungsdatenbank ermittelt wird, wobei für die Magnetresonanzdatensätze der Untersuchungsdatenbank ein Bildqualitätsparameter ermittelt wird und für aus den Patientendatensätzen ableitbare Körperformen mit den Sendesteuerparametern korreliert wird. Beispielsweise können für die Look-Up-Tabelle Körperformklassen definiert werden, für die Einträge in der Untersuchungsdatenbank hinsichtlich der Bildqualität verglichen werden. Die Sendesteuerparameter, die zu der besten Bildqualität geführt haben, können als Körperformparametern, die die entsprechende Körperformklasse beschreiben, zugeordnet in der Look-Up-Tabelle gespeichert werden. Soll als Ermittlungszusammenhang beispielsweise eine mathematische Formel bestimmt werden, kann ausgehend von den verschiedenen Körperformklassen für die Körperformparameter, die diese beschreiben, beispielsweise eine Interpolation oder dergleichen vorgenommen werden.

Anders gesagt können also Untersuchungsdatenbanken, die teilweise von Herstellern geführt werden, genutzt werden, um eine Datenbasis zu der in der klinischen Anwendung erzielten Bildqualität und den dabei verwendeten Steuerparametern bereitstehen zu haben, die im Rahmen der vorliegenden Erfindung verwendet werden. So können beispielsweise die konkret verwendeten Sendesteuerparameter mit interessierenden Bildqualitätsparametern korreliert werden und den Körperformen zugeordnet werden. Eine derartige Auswertung der Untersuchungsdatenbank, um den Ermittlungszusammenhang zu bestimmen, kann vorteilhafterweise automatisiert erfolgen. Eine Untersuchungsdatenbank kann beispielsweise Informationen betriebener Magnetresonanzeinrichtungen auch weiterhin sammeln, um den Ermittlungszusammenhang aktualisieren zu können, beispielsweise eine Look-Up-Tabelle mit ergänzenden Einträgen zu versehen. Zur Ermittlung des Bildqualitätsparameters kann beispielsweise allgemein vorgesehen sein, dass die Magnetresonanzdaten bezüglich der Gleichförmigkeit und/oder Homogenität der Helligkeit und/oder des Kontrasts innerhalb der äußeren Kontur des Patienten, also der Körperkontur, ausgewertet werden. Mit besonderem Vorteil können auch mehrere Zwischen-Bildqualitätsparameter in ein finales Qualitäts-Score, welches den letztendlich zu verwendenden Bildqualitätsparameter bildet, zusammengefasst werden, welches es erlaubt, das Sendesteuerparameterset, welches eingesetzt wurde, zu bewerten, insbesondere als gute, sinnvolle Sendesteuerparameter oder als schlechte Sendesteuerparameter, die in der Zukunft vermieden werden sollen.

Schließlich ist im Rahmen der vorliegenden Erfindung auch ein dritter Ansatz denkbar, um den Ermittlungszusammenhang zu ermitteln. Darin kann vorgesehen sein, dass der Ermittlungszusammenhang wenigstens teilweise durch eine Simulation wenigstens des Sendevorgangs der Sendespule basierend auf den Bloch-Gleichungen ermittelt wird, wobei unterschiedlichen Körperformen zugeordnete Menschmodelle der Simulation zugrunde gelegt werden. Dabei kann konkret vorgesehen sein, dass im Rahmen der Simulation ein Bl-Shimming simuliert wird und/oder die Menschmodelle aus einer insbesondere auf Daten vorangehender Patienten basierenden Modelldatenbank abgerufen werden.

Bezüglich dieses dritten Ansatzes wurde erkannt, dass die Simulationstechnik basierend auf den Bloch-Gleichungen inzwischen so weit fortgeschritten ist, dass in Abhängigkeit der jeweiligen Körperform optimale Sendesteuerparameter ermittelt werden können. Auch dies kann vorteilhafterweise automatisch erfolgen. In einer ersten Ausführungsform kann dabei ein Simulator genutzt werden, um offline, das bedeutet ohne Nutzung der Magnetresonanzeinrichtung, für Körperformparameter geeignete Sendesteuerparameter zu ermitteln. Im Falle einer Look-Up-Tabelle als Ermittlungszusammenhang können derart generierte, einander zugeordnete Informationen unmittelbar als Eintrag der Look-Up-Tabelle verwendet werden. Beispielsweise können verschiedene verfügbare Menschmodelle als Eingangsdaten für den Magnetresonanz-Simulator verwendet werden. In vorteilhafter Ausgestaltung kann der Simulator die Sendesteuerparameter iterativ unter Nutzung eines ähnlichen Algorithmus bzw. des gleichen Algorithmus verbessern, wie er für das Bl-Shimming genutzt wird. Geeignete Menschmodelle werden beispielsweise in der sogenannten "Virtual Population" von der IT'IS Foundation bereitgestellt.

Denkbar ist es jedoch auch, Menschmodelle aus Informationen anderer Patienten im sogenannten "digital twin"-Ansatz zu generieren, wie beispielsweise durch DE 10 2017 221 720 B3 offenbart.

Dabei sei an dieser Stelle angemerkt, dass ein patientenspezifisches, beispielsweise in einer elektronischen Patientenakte abgelegtes Patientenmodell des Patienten auch herangezogen werden könnte, um, insbesondere durch Simulation, optimale Sendesteuerparameter zu ermitteln. Eine derartige Simulation ist jedoch äußerst rechenaufwändig, nimmt also eine größere Zeit und/oder eine hohe Rechenleistung in Anspruch, die im Vorfeld einer Untersuchung nur schwer bereitstellbar ist.

Mithin sieht eine vorteilhafte Ausführungsvariante der vorliegenden Erfindung vor, dass ein patientenspezifischer vorbestimmter Ermittlungszusammenhang verwendet wird, der verschiedenen Körperregionen als Körperformparameter patientenspezifisch die optimierten Sendesteuerparameter zuordnet, wobei der Ermittlungszusammenhang insbesondere auf der Grundlage eines die Körperform, insbesondere die Körperkontur, beschreibenden, insbesondere in einer elektronischen Patientenakte geführten Patientenmodells ("digital twin") ermittelt wird und/oder wobei der Ermittlungszusammenhang vor der Untersuchung aus der elektronischen Patientenakte zur Verwendung in der Steuereinrichtung abgerufen wird. Auch in diesem Zusammenhang bietet sich als Ermittlungszusammenhang insbesondere eine Look-Up-Tabelle an, die dann Körperregionen für den Patienten optimierte Sendesteuerparameter für die Volumen-Sendespule zuordnet. Es wird also eine patientenindividuelle Optimierung bereitgestellt, ohne dass zum Zeitpunkt der Untersuchung aufwändige Berechnungen, insbesondere Simulationen wie oben beschrieben, durchgeführt werden müssen. Diese sind vielmehr bereits zu einem früheren Zeitpunkt erfolgt, besonders bevorzugt auf der Basis eines Patientenmodells in einer Patientenakte ("digital twin"), wie beispielsweise in der oben genannten DE 10 2017 221 720 B3 beschrieben. Der Ermittlungszusammenhang kann dann, gegebenenfalls mit dem Patientenmodell, als Teil der elektronischen Patientenakte abgespeichert werden und bei Bedarf abgerufen werden, um die Sendesteuerparameter hinsichtlich wenigstens einer bestimmten Körperregion zu ermitteln.

Neben dem Verfahren betrifft die vorliegende Erfindung auch eine Magnetresonanzeinrichtung, aufweisend eine zur Durchführung des erfindungsgemäßen Verfahrens ausgebildete Steuereinrichtung. Sämtliche Ausführungen bezüglich des erfindungsgemäßen Verfahrens lassen sich analog auf die erfindungsgemäße Magnetresonanzeinrichtung übertragen, so dass auch mit dieser die bereits genannten Vorteile erhalten werden können.

Die Steuereinrichtung kann insbesondere wenigstens einen Prozessor und wenigstens ein Speichermittel umfassen. In dem Speichermittel kann beispielsweise der Ermittlungszusammenhang abgelegt sein. Zur Durchführung der Schritte des erfindungsgemäßen Verfahrens kann die Steuereinrichtung beispielsweise eine erste Ermittlungseinheit für die Körperformparameter, eine zweite Ermittlungseinheit zur Ermittlung der Sendesteuerparameter unter Verwendung des Ermittlungszusammenhangs und eine Sequenzeinheit zur Steuerung der Aufnahme des Magnetresonanzdatensatzes aufweisen, wobei die Sequenzeinheit dann auch zur Ansteuerung der Sendespule unter Verwendung der Sendesteuerparameter ausgebildet ist. Selbstverständlich können für weitere Ausgestaltungen der vorliegenden Erfindung auch weitere Funktionseinheiten vorgesehen sein.

Ein erfindungsgemäßes Computerprogramm ist beispielsweise direkt in eine Steuereinrichtung einer Magnetresonanzeinrichtung ladbar und weist Programmmittel auf, um die Schritte eines erfindungsgemäßen Verfahrens durchzuführen, wenn das Computerprogramm auf der Steuereinrichtung der Magnetresonanzeinrichtung ausgeführt wird. Das Computerprogramm kann auf einem elektronisch lesbaren Datenträger gemäß der Erfindung gespeichert sein, welcher mithin darauf gespeicherte elektronisch lesbare Steuerinformationen umfasst, welche wenigstens ein erfindungsgemäßes Computerprogramm umfassen und bei Verwendung des Datenträgers in einer Steuereinrichtung einer Magnetresonanzeinrichtung bewirken, dass die Steuereinrichtung die Schritte eines erfindungsgemäßen Verfahrens durchführt. Bei dem Datenträger kann es sich insbesondere um einen nichttransienten Datenträger, beispielsweise eine CD-ROM, handeln.

Weitere Vorteile und Einzelheiten der vorliegenden Erfindung ergeben sich aus den im Folgenden beschriebenen Ausführungsbeispielen sowie anhand der Zeichnungen. Dabei zeigen:
- Fig. 1: einen Ablaufplan eines Ausführungsbeispiels des erfindungsgemäßen Verfahrens,
- Fig. 2: eine Prinzipskizze einer Volumen-Sendespule mit Birdcage-Aufbau,
- Fig. 3: eine beispielhafte Ausgestaltung einer Sendeelektronik für eine Sendespule,
- Fig. 4: eine Skizze zur Aufnahme von Sensordaten eines auf einer Patientenliege positionierten Patienten,
- Fig. 5: schematisch ein erstes Axialbild eines Patienten,
- Fig. 6: schematisch ein zweites Axialbild eines Patienten,
- Fig. 7: eine Prinzipskizze einer erfindungsgemäßen Magnetresonanzeinrichtung, und
- Fig. 8: den funktionalen Aufbau einer Steuereinrichtung der Magnetresonanzeinrichtung.

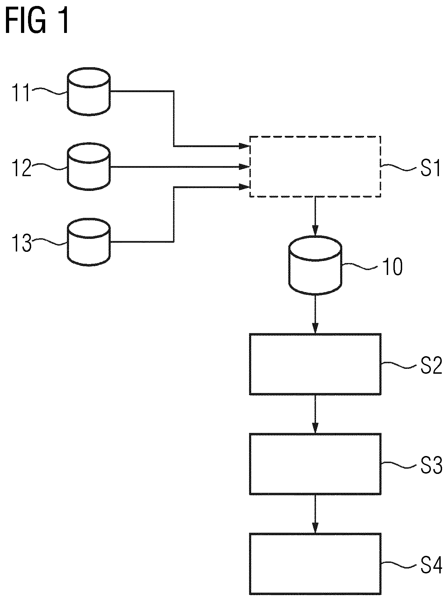

Fig. 1 zeigt einen Ablaufplan eines Ausführungsbeispiels des erfindungsgemäßen Verfahrens, welches beim Betrieb einer Magnetresonanzeinrichtung zur Aufnahme eines Magnetresonanzdatensatzes eines interessierenden Bereichs in einer Körperregion eines Patienten angewendet werden soll. Die Magnetresonanzeinrichtung weist dabei wenigstens eine Volumen-Sendespule auf, die gemäß einer zu verwendenden Magnetresonanzsequenz ein Anregungsfeld (B1-Feld) in den interessierenden Bereich ausstrahlen soll, welches zur Erzeugung einer hervorragenden Bildqualität möglichst rein zirkular polarisiert sein soll (B1⁻-Komponente im Wesentlichen Null) und möglichst homogen sein soll. Diesbezüglich stellt das hier dargestellte Ausführungsbeispiel optimierte Sendesteuerparameter für die Volumen-Sendespule bereit. Dabei sei bereits an dieser Stelle angemerkt, dass eine Magnetresonanzeinrichtung durchaus auch mehrere Volumen-Sendespulen aufweisen kann, beispielsweise als Ganzkörperspulen ausgebildete Volumen-Sendespulen oder aber auch kleinere, auf der Patientenliege positionierbare Volumen-Sendespulen, beispielsweise für den Kopf und/oder für Extremitäten. Diese Volumen-Sendespulen können beispielsweise als Birdcage-Sendespulen oder als TEM-Sendespulen ausgebildet sein.

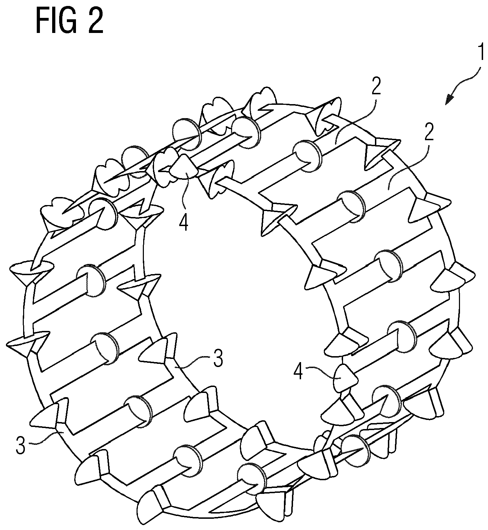

Fig. 2 zeigt zur Erläuterung ein Beispiel für eine Birdcage-Sendespule 1. Die Birdcage-Sendespule 1 umfasst im vorliegenden Ausführungsbeispiel sechzehn Sendestäbe 2, die sich in einer Längsrichtung erstrecken, die im Einsatz der sogenannten z-Richtung in der zylindrischen Patientenaufnahme der Magnetresonanzeinrichtung entspricht, mithin der Richtung des Grundmagnetfeldes (B0-Feldes). Die Sendestäbe 2 werden stirnseitig durch jeweils einen Endring 3 elektrisch verbunden. Im vorliegenden, einfachen Ausführungsbeispiel der Fig. 2 sind zudem zwei Speisepunkte 4 der Sendespule 1 gezeigt, die um 90° versetzt sind. Ohne einen Gegenstand innerhalb der Sendespule 1, mithin ohne Suszeptibilitätseffekte, kann dann, wenn die Speisepunkte 4, die als Ansteuerkanäle definierend verstanden werden können, mit gleicher Amplitude (Amplitudenverhältnis A₂/A₁ = 1) und mit einer Phasendifferenz ϕ₂ - ϕ₁ = 90° angesteuert werden, im Inneren der Sendespule 1 ein homogenes und rein zirkular polarisiertes Anregungsfeld (B1-Feld) dessen B1⁻-Komponente gleich Null ist, entstehen, so dass auch von einem B1⁺-Feld als Anregungsfeld geredet werden kann.

Für die Bildgebung ist ein derartiges Anregungsfeld erwünscht, wobei in der Praxis allerdings Abweichungen von der Homogenität auftreten können, welche die Bildqualität entsprechend einschränken können. Um diesen Effekten im Hinblick auf eine Verbesserung der Bildqualität entgegenzuwirken, wird das erfindungsgemäße Verfahren eingesetzt.

Dabei sei an dieser Stelle noch angemerkt, dass die in Fig. 2 gezeigte Volumen-Sendespule 1 im Birdcage-Aufbau rein beispielhaft zu verstehen ist. Insbesondere können moderne Volumen-Sendespulen wie Birdcage-Sendespulen/TEM-Sendespulen auch mehr als zwei Ansteuerkanäle aufweisen, mithin mehr als zwei Einspeisepunkte 4.

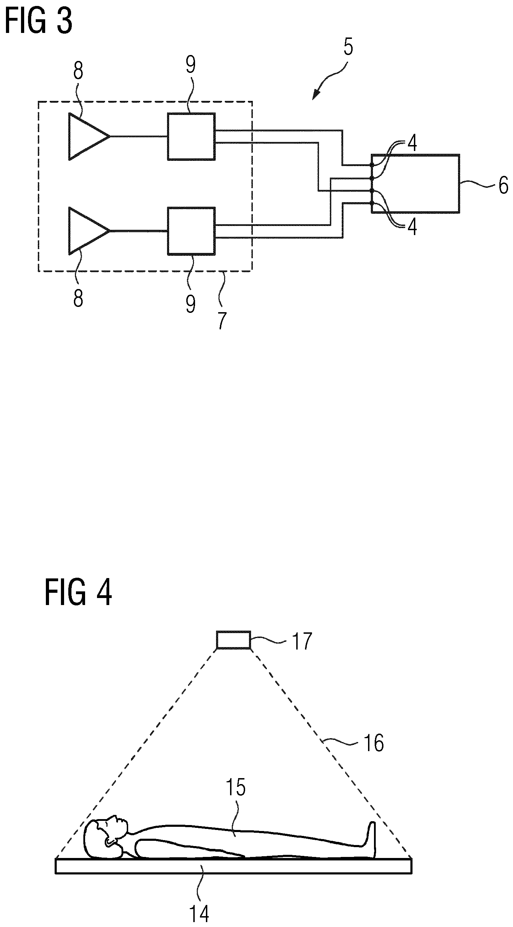

So zeigt beispielsweise Fig. 3 schematisch eine Sendeeinrichtung 5 für eine Magnetresonanzeinrichtung, bei der einer hier nicht im Detail gezeigten, im Birdcage-Aufbau oder TEM-Aufbau ausgeführten Volumen-Sendespule 6 eine Sendeelektronik 7 zugeordnet ist, um unterschiedliche Ansteuerungsvarianten für die in diesem Fall vier Ansteuerkanäle an den vier Speisepunkten 4 bereitzustellen. Im Ausführungsbeispiel der Fig. 3 weist die Sendeelektronik 7 zwei Hochfrequenz-Leistungsverstärker 8 und zwei steuerbare Hybridsplitter 9 auf. Durch Ansteuerung der Sendeelektronik 7, konkret der Hochfrequenz-Leistungsverstärker 8 und der Hybridsplitter 9, können gewünschte Phasenunterschiede und relative Amplituden/Amplitudenverhältnisse für die Sendekanäle an den Speisepunkten 4 eingestellt werden. Neben der in Fig. 3 beispielhaft dargestellten Ausgestaltung der Sendeelektronik 7 existieren eine Vielzahl von verschiedenen Möglichkeiten und Ausgestaltungen von Komponenten, welche teilweise auch Combiner umfassen können, um beispielsweise Hochfrequenzsignale zweier Hochfrequenz-Leistungsverstärker 8 zusammenzuführen. Wesentlich im Rahmen der vorliegenden Erfindung ist lediglich, dass eine Ansteuerung mit Sendesteuerparametern derart erfolgen kann, dass unterschiedliche Phasenunterschiede und/oder relative Amplituden an den Speisepunkten 4 eingestellt werden können.

Der in Fig. 1 gestrichelt dargestellte erste Schritt S1 kann optional zum erfindungsgemäßen Verfahren gehören, dies ist jedoch nicht zwangsläufig notwendig. In ihm wird vorbereitend ein Ermittlungszusammenhang, vorliegend eine Look-Up-Tabelle 10, ermittelt, die für eine Vielzahl von Messungen mit der Magnetresonanzeinrichtung herangezogen werden kann, um geeignete, das Anregungsfeld bezüglich der Homogenität und der rein zirkularen Polarisierung optimierende Sendesteuerparameter zu ermitteln. In der Look-Up-Tabelle 10 sind eine bestimmte Körperform, hier konkret Körperkontur, in einer Körperregion beschreibenden Referenz-Körperformparametern Sätze von Sendesteuerparametern zugeordnet, so dass im weiteren Verlauf des Verfahrens, wie noch erläutert werden wird, unter Kenntnis von Körperformparametern des aktuellen Patienten Sendesteuerparameter für die entsprechende Volumen-Sendespule 1, 6 ermittelt werden können, beispielsweise als die den die ähnlichste Körperkontur beschreibenden Referenz-Körperformparametern zugeordneten Sendesteuerparameter. Denkbar ist es selbstverständlich auch, durch Interpolation bezüglich der wenigstens zwei den die am besten übereinstimmende Körperkontur zeigenden Referenz-Körperformparametern zugeordneten Sendesteuerparameter einen anzuwendenden Satz an Sendesteuerparametern zu bestimmen. Zum Vergleich, inwiefern die Körperform, insbesondere die Körperkontur, übereinstimmt, kann beispielsweise ein Vergleichsmaß ermittelt werden.

Zur Bestimmung des Ermittlungszusammenhangs können verschiedene Ansätze herangezogen werden, die auch in Kombination einsetzbar sind.

In einem ersten Ansatz können in hinreichender Anzahl gezielt Messreihen mit Probanden durchgeführt werden und entsprechend dem Einfluss der Sendesteuerparameter auf die Bildqualität ausgewertet werden. Dabei kann beispielsweise vorgesehen sein, dass für jeden Probanden nicht nur die Körperformparameter bestimmt werden, sondern auch ein sogenanntes B1-Shimmung durchgeführt wird, bei dem iterativ im Rahmen eines Optimierungsverfahrens Sendesteuerparameter gewählt werden, das resultierende Anregungsfeld vermessen und bezüglich seiner Homogenität und dem Anteil der zirkularen Polarisierung beurteilt wird, woraus verbesserte Sendesteuerparameter für die nächste Iteration gewählt werden, bis eine hinreichende Konvergenz erzeugt ist. Die für den Probanden festgestellten Körperformparameter werden als Referenz-Körperformparameter in die Look-Up-Tabelle 10 eingetragen, wobei ihnen das Ergebnis des Bl-Shimmings zugeordnet wird. Entsprechende Messdaten 11 sind in Fig. 1 entsprechend angedeutet. Zur Messung sind selbstverständlich wenigstens baugleiche Volumen-Sendespulen 1, 6 zu verwenden.

In einem zweiten Ansatz wird eine Untersuchungsdatenbank 12 verwendet, in der Magnetresonanzdatensätze mit zugehörigen Patientendaten und Sendesteuerparametern für bereits erfolgte Untersuchungen gespeichert sind. Eine solche Untersuchungsdatenbank 12 kann beispielsweise anderweitig zur Analyse allgemein erreichbarer Leistungsfähigkeiten installierter, im Betrieb befindlicher Magnetresonanzeinrichtungen eingesetzt werden. Im Bezug auf die Ermittlung der Look-Up-Tabelle 10 können konkret verwendete Sendesteuerparameter für in der Untersuchungsdatenbank protokollierte Aufnahmevorgänge von Magnetresonanzdatensätzen mit Bildqualitätsparametern korreliert werden und den durch Patientendaten beschriebenen Körperformen, mithin Körperformparametern, zugeordnet werden. Eine derartige Auswertung kann automatisiert erfolgen. Insbesondere können beispielsweise Körperformklassen, gekennzeichnet durch bestimmte Körperformparameter oder auch Körperformparameterbereiche, festgelegt werden, für die dann jeweils Bildqualitätsparameter, beispielsweise betreffend die Einheitlichkeit und/oder Homogenität der Helligkeit und/oder des Kontrasts innerhalb des Patienten, verglichen werden und die Sendesteuerparameter, die zu der höchsten Bildqualität geführt haben, können der Körperformklasse zugeordnet werden. Nachdem der Körperformklasse auch bereits Körperformparameter zugeordnet sind, durch die sie definiert wird, existieren auch Referenz-Körperformparameter, so dass ein zugeordnetes Paar als Eintrag für die Look-Up-Tabelle 10 entsteht.

In einem dritten Ansatz können Simulationsergebnisse 13 herangezogen werden, um Einträge der Look-Up-Tabelle 10 zu ermitteln. Hierbei wird ein Simulator verwendet, der basierend auf den Bloch-Gleichungen den Betrieb der Magnetresonanzeinrichtung mit der Sendespule 1, 6, insbesondere im Rahmen eines Bl-Shimmings, simuliert. Hierzu können Menschmodelle herangezogen werden, die aus einer Modelldatenbank, welche beispielsweise auf Daten vorangehender Patienten basieren kann, abgerufen werden können und aus denen sich selbstverständlich auch entsprechende Körperformparameter ergeben. Beispielsweise können sogenannte "digitale Zwillinge" anonymisiert als Menschmodelle gesammelt und für die Simulation herangezogen werden.

Selbstverständlich sind grundsätzlich auch andere Varianten und Herangehensweisen denkbar, um eine hinreichende Anzahl von Einträgen in der Look-Up-Tabelle 10 zu erzeugen.

Die Körperformparameter können zumindest teilweise relativ allgemeine Angaben über den Patienten umfassen, beispielsweise die Patientengröße, das Patientengewicht und das Patientengeschlecht, und können zudem beispielsweise die Körperregion angeben, welche den interessierenden Bereich, von dem der Magnetresonanzdatensatz aufgenommen werden soll, enthält, welche mithin im Homogenitätsvolumen und somit auch innerhalb der Volumen-Sendespule 1, 6 platziert werden soll. Aus der Kenntnis der Körperregion und typischer Formen für beispielsweise Patientengrößen, Patientengewichte und Patientengeschlechter lässt sich die Körperform, insbesondere auch Körperkontur, im relevanten Gebiet zumindest grob abschätzen und verwenden.

In besonders vorteilhaften Ausgestaltungen, wie auch im hier dargestellten Ausführungsbeispiel, enthalten die Körperformparameter im tatsächlichen Anwendungsfall der Look-Up-Tabelle 10 durch Messung an dem Patienten gewonnene Informationen über die Körperkontur in der Körperregion. Dies wird im Folgenden noch genauer geläutert werden.

Zunächst aber wird nach der Ermittlung im Schritt S1 die für den Aufbau der Sendeeinrichtung 5 spezifische/gegebenenfalls auch für den Aufbau der Magnetresonanzeinrichtung spezifische Look-Up-Tabelle 10 an der Magnetresonanzeinrichtung zur Verfügung gestellt, um bei einer Vielzahl durchzuführender Untersuchungsvorgänge zur Aufnahme von Magnetresonanzdatensätzen von Patienten verwendet zu werden. Die Nutzung der Look-Up-Tabelle 10 bei einem Untersuchungsvorgang eines Patienten wird anhand der Schritte S2 bis S4 näher erläutert.

Zunächst werden in einem Schritt S2 die Körperformparameter des aktuellen Patienten ermittelt. Während es bei eher allgemeinen Angaben über den Patienten denkbar ist, diese beispielsweise aus einer Patientenregistrierung und/oder einer elektronischen Patientenakte abzurufen, ist für die die Körperkontur beschreibenden Körperformparameter bevorzugt im Schritt S2 eine Messung vorgesehen. Hierzu sind im Rahmen der vorliegenden Erfindung zwei Ansätze denkbar, die wiederum auch sich ergänzend verwendet werden können. In einem ersten diesbezüglichen Ansatz werden mit wenigstens einer 3D-Kamera und/oder einer Terahertz-Kamera Sensordaten des Patienten aufgenommen, und zwar bei bereits für die Aufnahme des Magnetresonanzdatensatzes auf einer Patientenliege der Magnetresonanzeinrichtung positioniertem, aber noch nicht in die Patientenaufnahme eingefahrenem Patienten. Eine beispielhafte Prinzipskizze diesbezüglich ist in Fig. 4 dargestellt. Dort ist der bereits für die Magnetresonanzuntersuchung auf der Patientenliege 14 positionierte Patient 15 gezeigt, der sich im Erfassungsbereich 16 der wenigstens einen 3D-Kamera 17 befindet, wobei zusätzlich oder alternativ eine Terahertz-Kamera vorgesehen sein kann, die durch Stoff und sonstige Gegenstände, die auf der Oberfläche des Patienten 15 befindlich sein können, hindurchblicken kann. Mittels eines geeigneten Auswertungsalgorithmus werden die Sensordaten der 3D-Kamera 17 hinsichtlich der Körperkontur, also des Verlaufs der Oberfläche des Körpers des Patienten 15, ausgewertet. Dabei kann für den aufgrund der Platzierung auf der Patientenliege 14 nicht einsehbaren Teil der Körperoberfläche angenommen werden, dass dieser auf der Patientenliege 14 aufliegt, deren Form bekannt ist.

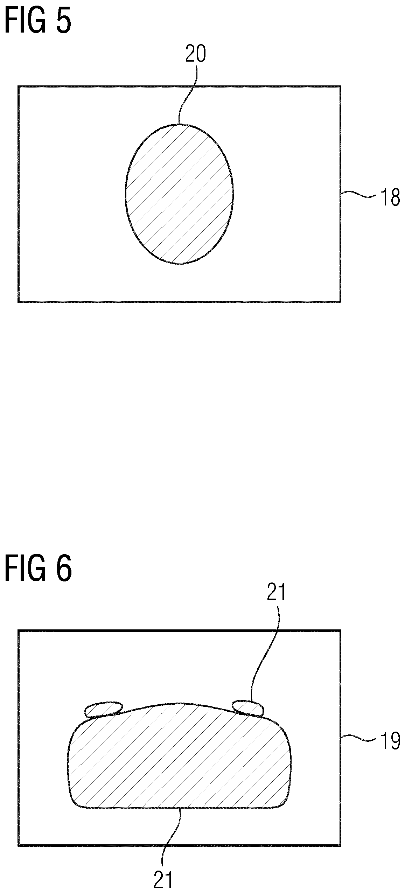

Alternativ oder zusätzlich kann im Schritt S2 die Messung beim Einfahren des Patienten 15 in die Patientenaufnahme der Magnetresonanzeinrichtung erfolgen, wobei in diesem Ausführungsbeispiel fortlaufend axiale Magnetresonanzbilder generiert werden, in denen dann die Körperkontur zeigende Umrandungslinien der Patientenanatomie durch automatische Auswertung bestimmt werden. Beispielhafte axiale Magnetresonanzbilder 18, 19 sind in den Figuren 5 und 6 angedeutet. Fig. 5 zeigt dabei als Körperkontur die Umrandungslinie 20 eines Kopfes eines Patienten, während in Fig. 6 die Umrandungslinie 21 des Abdomens mit aufliegenden Händen gezeigt ist, die ebenso die dortige Körperkontur beschreibt.

Um möglichst weitgehend Informationen zu erhalten, insbesondere für den gesamten Patienten, wird die Patientenliege 14 über die für die Aufnahme des Magnetresonanzdatensatzes geplante, die Körperregion mit dem interessierenden Bereich im Homogenitätsvolumen der Magnetresonanzeinrichtung platzierende Zielposition hinaus die Patientenliege derart in eine Vermessungsendposition verfahren, dass vorliegend der gesamte Patient von Kopf bis Fuß (bzw. je nach Orientierung von Fuß bis Kopf) durch axiale Magnetresonanzbilder 18, 19 erfasst wird, wonach die Patientenliege 14 von der Vermessungsendposition wieder in die Zielposition verfahren wird.

Aus den Sensordaten der wenigstens einen 3D-Kamera 17 bzw. den Magnetresonanzdaten der axialen Magnetresonanzbilder 18, 19 lässt sich ein Konturmodell des Körpers des Patienten 15 ermitteln. Nachdem bei den jeweiligen Datenermittlungen die Position der Patientenliege bekannt ist, ist mit der Zielposition der Patientenliege auch bekannt, welche Körperregion im Homogenitätsvolumen der Magnetresonanzeinrichtung bzw. im relevanten Bereich der Sendespule 1, 6 platziert ist, so dass ein entsprechender Anteil des Konturmodells als Körperformparameter ausgewählt werden kann. Dabei sei darauf hingewiesen, dass bei lokal anzuwendenden Volumen-Sendespulen, beispielsweise Kopfspulen und/oder Extremitätenspulen, auch bekannt ist, wo auf der Patientenliege 14 diese angeordnet sind, so dass entsprechende Schlussfolgerungen bezüglich des relevanten Anteils des Konturmodells gezogen werden können.

Sind die Körperformparameter im Schritt S2 bestimmt worden, wird im Schritt S3 die Look-Up-Tabelle 10 herangezogen, um aus dieser die Sendesteuerparameter abzurufen, für die die durch die Referenz-Körperformparameter beschriebene Körperkontur am besten der durch die im Schritt S2 bestimmten Körperformparameter des Patienten 15 beschriebenen Körperkontur entspricht.

In einem Schritt S4 erfolgt dann die Aufnahme des wenigstens einen Magnetresonanzdatensatzes des Patienten 15, wobei zur Ansteuerung der Sendeeinrichtung 5, konkret der Sendeelektronik 7, die Sendesteuerparameter, gegebenenfalls skaliert, verwendet werden, um Phasenunterschiede und/oder relative Amplituden an den Speisepunkten 4 zu erreichen, welche zu einer möglichst hohen Homogenität und rein zirkularen Polarisierung des Anregungsfeldes (B1-Feldes) innerhalb der Volumen-Sendespule 1, 6 führen, so dass eine hervorragende, hohe Bildqualität für den Magnetresonanzdatensatz erreicht wird.

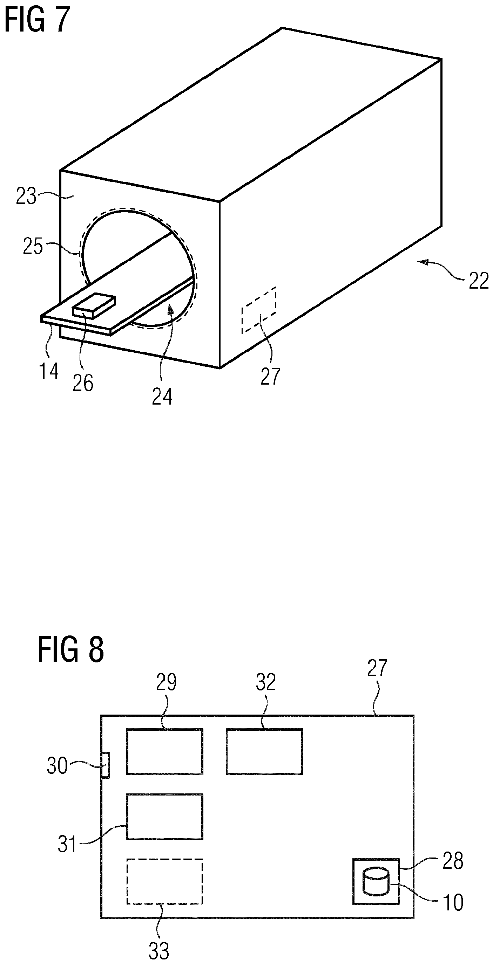

Fig. 7 zeigt eine Prinzipskizze einer erfindungsgemäßen Magnetresonanzeinrichtung 22. Diese umfasst, wie grundsätzlich bekannt, eine Hauptmagneteinheit 23, die den Grundfeldmagneten enthält und eine zylindrische Patientenaufnahme 24 aufweist, in die der Patient 15 mittels der Patientenliege 14 eingefahren werden kann. Dabei erstreckt sich im vorliegenden Ausführungsbeispiel eine als Ganzkörperspule ausgebildete Volumen-Sendespule 25 um die Patientenaufnahme 24 herum, beispielsweise nach innen auf eine hier nicht näher gezeigte Gradientenspulenanordnung folgend. Gezeigt ist auch eine zweite, beispielsweise für den Kopf des Patienten 15 anwendbare Volumen-Sendespule 26, die auf der Patientenliege 14 positioniert werden kann. Für beide Volumen-Sendespulen 25, 26 können in der Look-Up-Tabelle 10 Sendesteuerparameter, die Referenz-Körperformparametern zugeordnet sind, vorliegen.

Hierbei wird der Betrieb der Magnetresonanzeinrichtung 22 durch eine Steuereinrichtung 27 gesteuert, die zur Durchführung des erfindungsgemäßen Verfahrens ausgebildet ist. Bei den rein beispielhaften Volumen-Sendespulen 25, 26 kann es sich wiederum um Birdcage-Sendespulen oder TEM-Sendespulen handeln; die Zahl der Speisepunkte 4 bzw. Ansteuerkanäle ist dabei ebenso letztlich beliebig wählbar, genau wie die Ausgestaltung der zugehörigen Sendeelektronik 7. Wesentlich ist, dass unterschiedliche Ansteuerungsmöglichkeiten, beschrieben durch die Sendesteuerparameter, existieren, die bei unterschiedlichen Körperformen unterschiedliche Bildqualitäten liefern würden, wobei die Steuereinrichtung 27 mittels der Look-Up-Tabelle 10 für jede Körperform die am besten geeigneten Sendesteuerparameter und somit die am besten geeignete Bildqualität bereitstellen kann.

Fig. 8 zeigt den funktionalen Aufbau der Steuereinrichtung 27 genauer. Diese kann einen Prozessor aufweisen, mittels dem verschiedene Funktionseinheiten realisiert werden können. Daneben weist die Steuereinrichtung 27 auch ein Speichermittel 28 auf, in dem vorliegend unter anderem die Look-Up-Tabelle 10 für die Volumen-Sendespulen 25, 26 der Magnetresonanzeinrichtung 22 gespeichert ist.

Als Funktionseinheiten weist die Steuereinrichtung 27 zunächst eine erste Ermittlungseinheit 29 auf, in der gemäß dem Schritt S2 die Körperformparameter eines aktuellen Patienten 15 ermittelt werden können. Dabei können von einer Schnittstelle 30 die Sensordaten der wenigstens einen 3D-Kamera 17 erhalten werden. Gleichzeitig können von einer den Aufnahmebetrieb der Magnetresonanzeinrichtung und vorliegend auch das Verfahren der Patientenliege 14 steuernden Sequenzeinheit 31 axiale Magnetresonanzbilder 18, 19 erhalten werden.

In einer zweiten Ermittlungseinheit 32 wird die Look-Up-Tabelle 10 genutzt, um die für die Körperformparameter des aktuellen Patienten 15 am besten geeigneten Sendesteuerparameter zu ermitteln, vgl. Schritt S3. Diese Sendesteuerparameter werden dann wiederum an die Sequenzeinheit 31 weitergegeben, welche wenigstens einen Magnetresonanzdatensatz des interessierenden Bereichs des Patienten 15 aufnimmt, vgl. Schritt S4, wobei die Sendesteuerparameter entsprechend verwendet werden.

Optional kann die Steuereinrichtung 27 auch eine Bestimmungseinheit 33 zur Ermittlung der für die Untersuchungsvorgänge von Patienten 15 vorbestimmten Look-Up-Tabelle 10 als Ermittlungszusammenhang gemäß dem Schritt S1 aufweisen; dies kann jedoch auch über eine externe Recheneinrichtung erfolgen.

Dabei sei an dieser Stelle noch angemerkt, dass, obwohl die Steuereinrichtung 27 in Fig. 7 schematisch an der Hauptmagneteinheit 23 angedeutet ist, diese selbstverständlich wenigstens teilweise auch entfernt zu der Hauptmagneteinheit 23 angeordnet sein kann, beispielsweise in einem außerhalb einer Schirmkabine angeordneten Elektronikraum oder dergleichen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Computerimplementiertes Verfahren zum Betrieb einer Magnetresonanzeinrichtung (22), die wenigstens eine über wenigstens zwei Ansteuerkanäle ansteuerbare Sendespule (1, 6, 25, 26), der eine Sendeelektronik (7) zugeordnet ist, und eine Steuereinrichtung (27) aufweist, wobei die Steuereinrichtung (27) zur Ansteuerung der Sendespule (1, 6, 25, 26) zur Erzeugung eines Anregungsfeldes gemäß Sendesteuerparametern, die Phasenunterschiede und/oder relative Amplituden für die Ansteuerkanäle beschreiben, ausgebildet ist, **dadurch gekennzeichnet, dass** bei der Aufnahme eines Magnetresonanzdatensatzes eines interessierenden Bereichs eines Patienten (15) zur Ansteuerung der wenigstens einen Sendespule (1, 6, 25, 26)
- wenigstens ein die Körperform, insbesondere Körperkontur, des Patienten (15) wenigstens in einer den interessierenden Bereich umfassenden Körperregion und/oder die Körperregion beschreibender Körperformparameter ermittelt wird,
- Sendesteuerparameter für die Sendespule (1, 6, 25, 26) mittels eines vorbestimmten, in der Steuereinrichtung (27) abgelegten Ermittlungszusammenhangs ermittelt werden, wobei der Ermittlungszusammenhang Körperformparametern bezüglich der Erzeugung eines rein zirkular polarisierten und/oder homogenen Anregungsfelds optimierte Sendesteuerparameter für die Sendespule (1, 6, 25, 26) zuordnet, und
- die Sendespule (1, 6, 25, 26) unter Verwendung der Sendesteuerparameter angesteuert wird.

2. Verfahren nach Anspruch 1, **dadurch gekennzeichnet, dass** als der Ermittlungszusammenhang eine Look-Up-Tabelle (10) verwendet wird.

3. Verfahren nach Anspruch 2, **dadurch gekennzeichnet, dass** bei die Körperkontur des Patienten (15) in der Körperregion beschreibenden Körperformparametern die Sendesteuerparameter der Look-Up-Tabelle (10) ausgewählt werden, deren zugeordnete Körperkontur der Körperkontur des Patienten (15) am besten entspricht.

4. Verfahren nach einem der vorangehenden Ansprüche, **dadurch gekennzeichnet, dass** die Körperformparameter, insbesondere bezüglich der Körperkontur, wenigstens teilweise durch eine Messung an dem Patienten (15) ermittelt werden.

5. Verfahren nach Anspruch 4, **dadurch gekennzeichnet, dass** die Körperkontur des Patienten (15) mittels einer wenigstens die Körperregion erfassenden 3D-Kamera (17) und/oder einer Terahertz-Kamera und/oder, insbesondere wenigstens teilweise beim Einfahren des Patienten (15) auf einer Patientenliege (14) in eine Patientenaufnahme (24) der Magnetresonanzeinrichtung (22), durch Aufnahme von Magnetresonanzdaten mit der Magnetresonanzeinrichtung (22) vermessen wird, wobei aus den Sensordaten der 3D-Kamera (17) und/oder Terahertz-Kamera und/oder den Magnetresonanzdaten ein die Oberfläche des Körpers des Patienten (15) beschreibendes Konturmodell ermittelt wird, aus dem wenigstens ein Teil der Körperformparameter ermittelt wird.

6. Verfahren nach Anspruch 5, **dadurch gekennzeichnet, dass** die Magnetresonanzdaten als während des Einfahrvorgangs in verschiedenen Positionen der Patientenliege (14) aufgenommene axiale Magnetresonanzbilder (18, 19) aufgenommen werden, aus denen das Konturmodell bestimmt wird, und/oder dass der Einfahrvorgang über eine Zielposition, in der der interessierende Bereich in einem Homogenitätsvolumen der Magnetresonanzeinrichtung (22) positioniert ist, hinaus unter weiterer Aufnahme von Magnetresonanzdaten bis in eine Vermessungsendposition erfolgt, wonach die Patientenliege (14) von der Vermessungsendposition in die Zielposition verfahren wird.

7. Verfahren nach Anspruch 5 oder 6, **dadurch gekennzeichnet, dass** eine 3D-Kamera (17) und/oder eine Terahertz-Kamera mit einem außerhalb der Patientenaufnahme (24) befindlichen Erfassungsbereich (16) verwendet wird, wobei die Sensordaten vor Einfahren des Patienten (15) in die Patientenaufnahme (24) aufgenommen werden.

8. Verfahren nach einem der Ansprüche 5 bis 7, **dadurch gekennzeichnet, dass** aus einer oder der für die Aufnahme des Magnetresonanzdatensatzes eingenommenen Zielposition der Patientenliege (14) die Körperregion und/oder ein als Körperformparameter zu verwendender Anteil des Konturmodells bestimmt wird.

9. Verfahren nach einem der vorangehenden Ansprüche, **dadurch gekennzeichnet, dass** der Ermittlungszusammenhang wenigstens teilweise durch eine Vorabmessung mit einer Mehrzahl von Körperformen ermittelt wird, insbesondere aus Ergebnissen (11) eines Bl-Shimming mit der Magnetresonanzeinrichtung (22) für mehrere, unterschiedliche Körperformparameter aufweisende Patienten (15).

10. Verfahren nach Anspruch 9, **dadurch gekennzeichnet, dass** bei dem Bl-Shimming eine iterative, optimierende Anpassung der Sendesteuerparameter aufgrund intermittierender Messungen des Anregungsfeldes mit der Magnetresonanzeinrichtung (22) vorgenommen wird.

11. Verfahren nach einem der vorangehenden Ansprüche, **dadurch gekennzeichnet, dass** der Ermittlungszusammenhang wenigstens teilweise durch Auswertung einer Magnetresonanzdaten mit zugehörigen Patientendaten und Sendesteuerparametern enthaltenden Untersuchungsdatenbank (12) ermittelt wird, wobei für die Magnetresonanzdaten der Untersuchungsdatenbank (12) ein Bildqualitätsparameter ermittelt wird und für aus den Patientendaten ableitbare Körperformen mit den Sendesteuerparametern korreliert wird, und/oder dass der Ermittlungszusammenhang wenigstens teilweise durch eine Simulation wenigstens des Sendevorgangs der Sendespule (1, 6, 25, 26) basierend auf den Bloch-Gleichungen ermittelt wird, wobei unterschiedlichen Körperformen zugeordnete Menschmodelle der Simulation zugrunde gelegt werden, wobei insbesondere im Rahmen der Simulation ein Bl-Shimming simuliert wird und/oder die Menschmodelle aus einer insbesondere auf Daten vorangehender Patienten (15) basierenden Modelldatenbank abgerufen werden.

12. Verfahren nach einem der vorangehenden Ansprüche, **dadurch gekennzeichnet, dass** ein patientenspezifischer vorbestimmter Ermittlungszusammenhang verwendet wird, der verschiedenen Körperregionen als Körperformparameter patientenspezifisch die optimierten Sendesteuerparameter zuordnet, wobei insbesondere der Ermittlungszusammenhang auf der Grundlage eines die Körperform, insbesondere die Körperkontur, beschreibenden, insbesondere in einer elektronischen Patientenakte geführten Patientenmodells des Patienten (15) ermittelt wird und/oder wobei insbesondere der Ermittlungszusammenhang vor der Untersuchung aus der elektronischen Patientenakte zur Verwendung in der Steuereinrichtung (27) abgerufen wird.

13. Magnetresonanzeinrichtung (22), aufweisend eine zur Durchführung eines Verfahrens nach einem der vorangehenden Ansprüche ausgebildete Steuereinrichtung (27).

14. Computerprogramm, welches die Schritte eines Verfahrens nach einem der Ansprüche 1 bis 12 durchführt, wenn es auf einer Steuereinrichtung (27) einer Magnetresonanzeinrichtung (22) ausgeführt wird.

15. Elektronisch lesbarer Datenträger, auf dem ein Computerprogramm nach Anspruch 14 gespeichert ist.
